Europäisches Patentamt

(19) European Patent Office

Office européen des brevets

(11) Publication number: **0 310 152**
**A2**

# (12) EUROPEAN PATENT APPLICATION

(21) Application number: **88201652.0**

(22) Date of filing: **01.08.88**

(51) Int. Cl.⁴: **G01R 31/28**

(30) Priority: **28.09.87 GB 8722770**

(43) Date of publication of application:
**05.04.89 Bulletin 89/14**

(84) Designated Contracting States:
**AT BE CH DE ES FR GR IT LI LU NL SE**

(71) Applicant: **PLESSEY OVERSEAS LIMITED**
**Vicarage Lane**
**Ilford Essex IGI 4AQ(GB)**

(72) Inventor: **Wood, Paul Anthony**
**35 Haglane Copse**
**Pennington Lymington Hampshire(GB)**

(74) Representative: **Elliott, Frank Edward**
**The Plessey Company plc. Intellectual**
**Property Department Vicarage Lane**
**Ilford, Essex IG1 4AQ(GB)**

(54) **Test overlay circuit.**

(57) A test overlay circuit, for interposing between logic blocks of a circuit to be tested, is arranged to operate as a conventional buffer between the logic blocks in a first mode of operation but is provided with scan-in and scan-out ports, a register and multiplexers providing path controlling mean enabling test patterns to be loaded into the register from the scan-in port and fed from the register to the downstream logic block, or enabling data-in (a test pattern) from the up-stream logic block to be fed to the register. The circuit enables the simultaneous loading, receiving and sending of discrete test patterns for testing the logic blocks.

EP 0 310 152 A2

## TEST OVERLAY CIRCUIT

This invention relates to test overlay circuits for use in the testing of circuit boards using Scan-in and Scan-out techniques. Scan path techniques have been used heretofore to aid in the testing of circuit board elements. It is necessary to provide externally accessible nodes in order that a test pattern may be applied to a circuit element. Often, a method is used that initiates the discrete 'Bed of Nails' technique wherein a number of nodes are made accessible to a series of chips which serialise the mechanisms involved in driving and monitoring these nodes. Consequently, the number of circuit elements testable in this way has been increased. These techniques do not overcome the limitation of what is called "back driving" of the circuit element to establish an appropriate test path. In other implementations it has been necessary to replace all D type Flip/Flops with a specific test circuit to enable limited scan path element testing. This solution only provides access to those parts of the circuit that are synchronised.

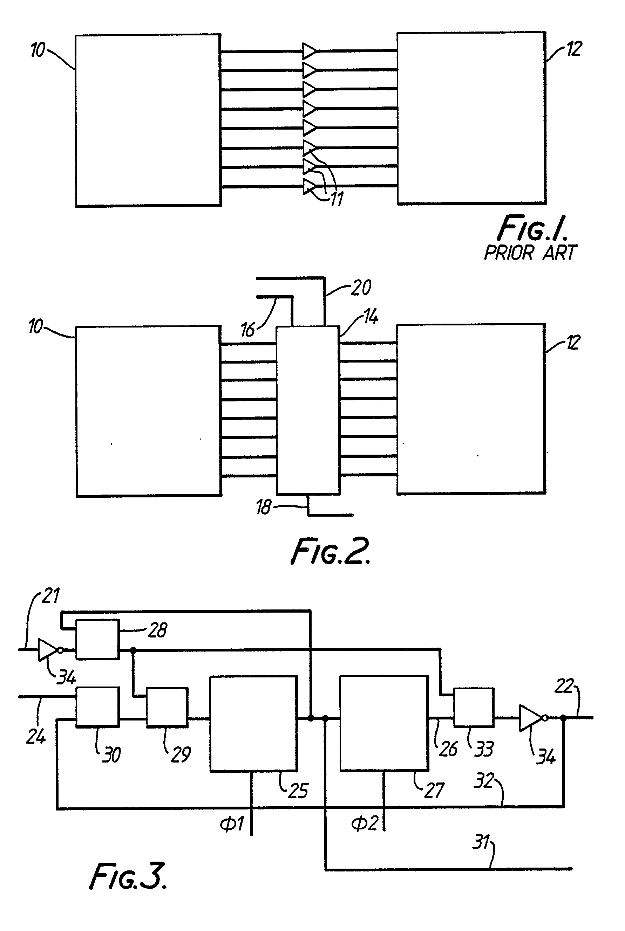

Figure 1 shows a block diagram of a conventional logic circuit including a logic block 10 having a plurality of outputs each buffered by a buffer element 11 and then fed to the respective inputs of a second logic block 12.

An inordinately large number of externally accessible nodes is required if each of the circuit elements of the block 10 or the block 12 is to be tested.

It is an object of the present invention to provide a test overlay circuit wherein the aforesaid limitation and disadvantages are minimised or overcome.

According to the present invention, there is provided a test overlay circuit arranged to act as a buffer between logic blocks of a circuit and to provide a buffered data path from a data-in port associated with the first logic block to a data-out port associated with the second logic block, the overlay circuit comprising a scan-in port and a scan-out port, a register whereinto or wherefrom data may be clocked and a plurality of multiplexers controllably differing said data path, a path from said data-in port to the register, a path from the register to the data-out port, and a path from the register to the scan-out port.

The invention will be described further, by way of example, with reference to Figures 2 and 3 of the accompanying drawings, in which:-
Figure 2 is a block schematic drawing of a logic circuit including a synchronous test overlay circuit according to the present invention; and
Figure 3 is a block diagram of one stage of the test overlay circuit shown in Figure 1.

As shown in Figure 2, the conventional buffer 11 normally provided between logic blocks 10 and 12 is replaced by a synchronous test overlay circuit 14 in accordance with the present invention.

The circuit 14, in normal operation, acts as a conventional buffer but, for test purposes, is provided with a scan-in input 16, a scan-out output 18 and a control input 20. Under appropriate control via the input 20, various scan paths can be established. It will be appreciated that a similar test overlay circuit is provided between the logic block 10 and a preceding logic block (not shown) and between the logic block 12 and a succeeding logic block (also not shown) as necessary. The input 16 and the output 18 may be common to all the test overlay circuits provided, and the particular ones can be rendered operative by appropriate control signals at the input 20. The number of externally accessible locations is thereby reduced to a minimum.

Referring now to Figure 3, one stage of the synchronous test overlay circuit according to the present invention is shown. It will be appreciated that each buffer element of the buffer 11 is replaced by one of the stages shown in Figure 3. Each stage is arranged, in normal operation, to buffer data in one of the paths from logic block 10 to the next logic block 12. The path for such normal operation is via a data-in port 21, a multiplexer 28, a line 23, a multiplexer 33 to a data out port 22. Such paths 23 would normally include invertors 34 as shown. A scan-in port 24 and a scan-out port 31 correspond respectively to the scan-in input 16 and the scan-out output 18 and, as stated, they may be common to all of the overlay circuits provided.

A path is provided from the data-in port 21, via the multiplexer 28, a multiplexer 29, and a shift register 25 to the scan-out port 31.

A path is provided from the scan-in port 24 via a multiplexer 30, the multiplexer 29, the shift register 25, a shift register 27, a line 26 and the multiplexer 33 to the data-out port 22.

A path 32 is provided from the data-out port 22 back to the multiplexer 30.

A clock $\emptyset_1$ input is provided to the shift register register 25 and a clock $\emptyset_2$ input is provided to the shift register 27. It will be appreciated that the multiplexers 28, 29, 30 and 33 are operated under the control of signals fed thereto by a control bus through input 20 (Figure 2).

The synchronous test overlay circuit of the present invention can operate in various modes as follows:-

## Mode "0" (normal operation)

As described above, in normal operation data is fed from logic block 10 (Figure 2) through data-in terminal 21, inverter 34, multiplexer 28, line 23, multiplexer 33, inverter 35 to data-out terminal 22 with little or no delay. The circuit thus operates as a buffer. Simultaneously, for test purposes, a test pattern can be clocked into shift register 25 from scan-in port 24 through multiplexers 30 and 29, on application of $\phi_1$ clock signals. By control of the multiplexers 30 and 29, the test patterns can be loaded into the shift registers 25 of a plurality of stages either simultaneously, if the test patterns are the same, or sequentially if different test patterns are to be loaded.

## Mode "1"

In this mode, the multiplexer 33 selects the path 26, disabling the path 23. Data (a test pattern) previously loaded in shift register 25 can be clocked into shift register 27 and out upon $\phi_2$ clock signals through the data port 22 to a circuit of the next logic block element which circuit is to be tested. Also in Mode 1, multiplexers 28 and 29 are operated to divert data in (a test pattern from a circuit of the logic block 10) from port 21 into register 25 an $\phi_1$ clock signals.

## Mode "2"

In Mode 2, multiplexers 30 and 29 select the scan-in port 24, leaving the path 23 disabled and the path 26 enabled. Data (a test pattern) in register 27 is still applied to the data-out port 22. Application of $\phi_1$ clock signals shifts the previously sampled data in register 25 to the scan-out port 31 for analysis. If a new test pattern is simultaneously supplied at the scan-in port 24, this will be loaded into the register 25 at the same time. Thus, in this mode, a test pattern is being applied from register 27 to a circuit element of logic block 12, test results of a test pattern previously applied to a circuit element of the logic block 10 are being fed out from register 25 for analysis, and a new test pattern is being loaded into register 25 is for subsequent use in testing the ciruit element of logic block 12 or in self-test. These three operations can be effected simultaneously.

## Mode "3"

This Mode is a "self-test" mode and is used for testing the stage itself. Path 32 is used to test path 23. A test pattern is clocked out of register 25 by $\phi_1$ clock signals and via the multiplexer 28 is fed along path 23, through multiplexer 33 and inverter 35 to the data-out port 22 and the line 32 to the multiplexers 30 and 29, back into register 25 from where it can subsequently be sampled in Mode 2.

It can be seen that, in conjunction with similar synchronous test overlay circuits preceding logic block 10 and subsequent to logic block 12, the circuit provides for testing of circuit elements of the logic blocks.

By appropriate operation of the control circuit, the requirement for externally accessible nodes is reduced to a minimum thus enabling more circuit elements to be tested.

The provision for simultaneous input, supply and sampling of test patterns, as described in relation to the Mode 2 operation expedites the testing of a circuit.

The invention is not confined to the precise details of the foregoing example and variations may be made thereto. For instance, the stages of the test overlay circuit may be arranged seriatim with a scan-out port of one stage constituting a scan-in port of a subsequent stage, with the control signals being common. The port then acts in accordance with whether data is supplied thereto or read therefrom. The $\phi_1$ and $\phi_2$ clock signals may be opposite phases of or alternate phases of the same clock or may be provided by seperate clocks. Other variations are possible within the scope of the present invention.

## Claims

1. A test overlay circuit arranged to act as a buffer between logic blocks of a circuit and to provide a buffered data path from a data-in port associated with the first logic block to a data-out port associated with the second logic block, the overlay circuit comprising a scan-in port and a scan-out port, a register whereinto or wherefrom data may be clocked and a plurality of multiplexers controllably defining said data path, a path from said data-in port to the register, a path from the register to the data-out port and a path from the register to the scan-out port.

2. A circuit as claimed in claim 1 further including a second register interposed on the path between the first register and the data-out port.

3. A circuit as claimed in claim 1 or 2 further including a path from the register or the first register to a multiplexer controlling the data path.

4. A circuit as claimed in claimed in claim 1 or 2 or 3 further including a path from the data-out port to a multiplexer controlling a path from the scan-in port to the register or to the first register.

5. A circuit as claimed in claim 2 or any claim appendant thereto wherein the first and second registers are shift registers.

6. A circuit as claimed in claim 5 further including means for applying respective clock signals to the first and second registers.

7. A test overlay circuit substantially as hereinbefore described with reference to and as illustrated in Figures 2 and 3 of the accompanying drawings.

8. A test overlay circuit as claimed in any preceding claim arranged to operate in a plurality of modes and in which, in a first mode, the circuit is arranged to feed data from the data-in port to the data-out port and, simultaneously, to feed data (a test pattern) from said scan-in port to the register.

9. A circuit as claimed in claim 8 arranged to operate in a second mode in which data (a test pattern) is fed from the data-in port to the register and, simultaneously, a test pattern is fed from the register to a second register.

10. A circuit as claimed in claim 8 wherein, in the second mode, a test pattern is arranged to be fed, simultaneously, from the second register to the data-out port.

11. A circuit as claimed in claim 10 further including a path from the data-out port, through a multiplexer to the first register.

12. A circuit as claimed in claim 11 further including a path from the first register to a multiplexer controlling the data-in port and hence to the data-out port.

*Fig.1.*
PRIOR ART

*Fig.2.*

*Fig.3.*